# EUROPÄISCHE PATENTSCHRIFT

(11) **EP 0 346 817 B1**
(45) Veröffentlichungstag und Bekanntmachung des Hinweises auf die Patenterteilung: **26.10.1994**
(21) Anmeldenummer: 89110648.6
(22) Anmeldetag: 13.06.1989
(51) Int. Cl.: G01R 33/06

(54) **Magnetfeldsensor mit ferromagnetischer, dünner Schicht**
Magnetic field sensor with a thin ferromagnetic layer
Détecteur de champ magnétique avec une couche mince ferromagnétique

(30) Priorität: 16.06.1988 DE 3820475
(43) Veröffentlichungstag der Anmeldung: 20.12.1989
(73) Patentinhaber: FORSCHUNGSZENTRUM JÜLICH GMBH, 52425 Jülich (DE)
(72) Erfinder: Grünberg, Peter, Dr., D-5170 Jülich (DE)

(56) Entgegenhaltungen:
- EP-A- 0 063 397
- US-A- 4 103 315
- US-A- 4 356 523
- PHYSICAL REVIEW, B. CONDENSED MATTER. Bd. 39, Nr. 7, März 1989, NEWYORK US Seiten 4828 - 4830; G. BINASCH ET AL.: 'Enhanced Magnetoresistance inlayered magnetic structures with antiferromagnetic interlayer exchange'
- PHYSICAL REVIEW LETTERS. Bd. 61, Nr. 21, 21. November1988, NEW YORK US Seiten 2472 - 2475; BAIBICH ET AL.: 'giant magnetoresistanceof (001)Fe/(001)Cr Magnetic Superlattices'
- PHYSICAL REVIEW, B. CONDENSED MATTER. Bd. 42, Nr. 13A, 1. November1991, NEW YORK US Seiten 8110 - 8120; J. BARN S ET AL.: 'Novelmagnetoresistance effect in layered magnetic structures: Theory and Experiment'

## Beschreibung

Die Erfindung bezieht sich auf einen Magnetfeldsensor zum Auslesen magnetisch gespeicherter Daten, der wenigstens zwei über eine Zwischenschicht benachbarte ferromagnetische dünne Schichten aufweist, die aus Materialien bestehen, die bewirken, daß entweder ohne oder unter Mitwirkung eines äußeren Magnetfeldes die Magnetisierungsrichtungen der beiden ferromagnetischen Schichten in einer Komponente antiparallel zueinander stehen, wobei die Zwischenschicht aus nicht-magnetischem Metall besteht, und mit zugehörigen Strom- und Spannungskontakten.

Ein Magnetfeldsensor dieser Art ist aus der europäischen Patentanmeldung 0 063 397 bekannt. Das Anwendungsgebiet dieser Magnetfeldsensoren ist in erster Linie das Auslesen magnetisch gespeicherter Daten (z.B. Festplatte, Floppy-Disk, Magnetbänder), aber auch alle Anwendungen, bei denen es auf den Nachweis von Magnetfeldern mit hoher Ortsauflösung ankommt.

Durch den Einfluß der aus dem Datenspeicher austretenden Magnetfelder wird die Magnetisierungsrichtung bzw. die Domänenstruktur in den magnetischen Schichten des Magnetfeldsensors verändert. Dies hat infolge des sog. anisoptropen Magnetwiderstandseffektes eine Veränderung des elektrischen Widerstandes und damit Spannungsabfalls U zur Folge. Das damit erhaltene elektrische Signal wird sodann mit den bekannten Mitteln weiterverarbeitet. Bei einzelnen Filmen (meist aus Permalloy) beträgt die Änderung des Magnetwiderstandes, auf der das Meßsignal beruht, maximal ca. 3 %. Zwar hängt die Güte des Meßsignals vornehmlich vom Signal-Rausch-Verhältnis ab. Dennoch ist auch eine Erhöhung des Meßsignals erwünscht.

Es ist daher Aufgabe der Erfindung, einen Magnetfeldsensor zu schaffen, bei dem die Änderung des Magnetwiderstandes und damit das Meßsignal größer ist als bei den bisher bekannten Magnetfeldsensoren.

Die der Erfindung zugrundeliegende Aufgabe wird durch einen Magnetfeldsensor mit den kennzeichnenden Merkmalen des Anspruchs 1 gelöst.

Mit der Zwischenschicht gemäß der Erfindung wird eine Erhöhung des Meßsignals um wenigstens den Faktor 3 erzielt.

Die Lehre gemäß der Erfindung macht davon Gebrauch, daß die Änderung des Magnetwiderstandes, die das Meßsignal erzeugt, auf die magnetische Streuung von Leitungselektronen zurückzuführen ist. Diese beruht darauf, daß die magnetischen Momente von Elektronen, die eine magnetische Schicht durchlaufen, ausgerichtet werden. In magnetischen Schichtstrukturen, wie sie hier betrachtet werden, kann die Streuung von Elektronen und damit der elektrische Widerstand durch antiparallele Ausrichtung der Magnetisierung vergrößert werden. Man führt diesen Effekt auf eine unterschiedliche Streurate von Elektronen mit Spinausrichtung parallel und antiparallel zur Magnetisierung zurück. Eine solche, von der Spinausrichtung abhängige Streuung von Elektronen ist von massiven magnetischen Materialien, die nichtmagnetische Verunreinigungen enthalten, aus J.W.F. Dorleign, Philips Res. Repts. 31, 287, 1976 bzw. I.A. Campbell and A. Fert in "Ferromagnetic Materials", Vol. 3 ed. by E.P. Wohlfarth, North-Holland Publ. Comp., 1982, bekannt. Dort ist die Streuung der Elektronen an den Verunreinigungen für die beiden Spinausrichtungen verschieden. Numerische Werte für das Verhältnis der Streuraten sind der genannten Literatur zu entnehmen. In den geschichteten Strukturen gemäß der Erfindung spielen die nichtmagnetischen Zwischenschichten die gleiche Rolle wie die Verunreinigungen in den massiven Materialien. Die Streuung erfolgt jetzt an den Grenzflächen. Wegen der Verwandtschaft der Effekte kann man die von den Legierungen her bekannten Daten zu einer Auswahl geeigneter Materialkombinationen für die Schichtstrukturen benutzen.

In den geschichteten Strukturen ergibt sich außerdem die Möglichkeit, den Winkel zwischen den Magnetisierungsrichtungen benachbarter ferromagnetischer Schichten zu ändern. Angenommen man wählt nun für die Zwischenschicht ein Material, das für die beiden Spinorientierungen eine stark unterschiedliche Streurate an den Grenzflächen bewirkt. Sind die ferromagnetischen Schichten parallel ausgerichtet, so werden nur Elektronen mit einer Spinorientierung stark gestreut. Bei antiparalleler Ausrichtung der Magnetisierungen werden Elektronen mit beiden Spinorientierungen stark gestreut und der elektrische Widerstand vergrößert sich. Damit ergibt sich ein Widerstandseffekt, der von dem Winkel φ zwischen den Magnetisierungen der ferromagnetischen Schichten abhängt, der hier in einem Sensor ausgenutzt wird. Das Signalfeld Hₛ verändert dabei den Winkel φ und somit den elektrischen Widerstand.

Schichtstrukturen, bei denen die Magnetisierungsrichtungen benachbarter ferromagnetischer Schichten relativ zueinander gedreht sind, sind noch aus einem anderen, bereits bekannten Grund von besonderem Interesse für Magnetfeldsensoren. Durch die teilweise antiparallele Ausrichtung werden die Streufelder am Sensorrand reduziert, so daß Randdomänen vermieden werden können. Dies vermindert das Detektorrauschen und wirkt sich somit günstig auf das Signal-Rausch-Verhältnis aus. Maßnahmen, um die gewünschte Ausrichtung der Magnetisierungen zu erreichen, sind daher bekannt und sind Stand der Technik. Typischerweise müssen in diesen Fällen die Zwischenschichten genügend dick gewählt werden, so daß die magnetischen Schichten entkoppelt sind. Die Erfindung bezieht sich in diesen Fällen auf die verwendeten Materialien, die mit Hilfe des neuen Magnetwiderstandseffektes zu einer Vergrößerung des Signales führen. Die Lehre, die im allgemeinen Fall Anwendung finden kann, ist, hier Materialkombinationen zu verwenden, bei denen sich an den Zwischenschichten eine starke Abhängigkeit der Elektronenstreuung von der Spinausrichtung ergibt. Werte für das Verhältnis der Streuraten sind der vorgenannten Literatur zu entnehmen.

Gemäß der Erfindung wird eine neue Möglichkeit gegeben, wie man die zueinander gedrehten Ausrichtungen der Magnetisierungen erreichen kann. Sie nutzt den Effekt der antiferromagnetischen Zwischenschichtkopplung aus, und es werden Materialien angegeben, die gleichzeitig diesen Effekt und den Widerstandseffekt durch spinrichtungsabhängige Elektronenstreuung zeigen.

Wenn man eine antiparallele Ausrichtung der Magnetisierungen ( φ = 180) eingestellt hat, und zwar in der Weise, daß die Magnetisierungen senkrecht zum Signalfeld Hₛ stehen, dann kann man den optimalen Winkel φ während des Betriebes des Sensors auf die Weise erreichen, daß man Hₛ ein geeignetes Bias-Feld Hb² überlagert. Falls die Widerstandsänderung durch das Signal Hₛ für φ = 180 groß genug ist, ist ein Bias-Feld Hb² nicht nötig. Möglicherweise muß jedoch ein anderes Bias-Feld, Hb¹, angewendet werden, um vor dem Betrieb des Sensors die antiparallele Ausrichtung zu erreichen. Hier wird angenommen, daß dieses Bias-Feld parallel zur Sensorebene, senkrecht zur Richtung von Hₛ wirkt.

Bei einer ersten Ausführungsart des Magnetfeldsensors sind die ferromagnetischen Schichten aus Materialien mit unterschiedlichen Koerzitivfeldstärken H_{c} vorgesehen. Die beiden ferromagnetischen Schichten sind dabei durch eine Zwischenschicht aus nichtmagnetischem Metall entkoppelt. Die antiparallele Ausrichtung der Magnetisierung der Schichten wird in diesem Falle beim Durchlaufen der Magnetisierungskurve des Schichtpakets für bestimmte Werte eines äußeren Magnetfeldes erreicht, das beispielsweise durch einen Permanentmagneten erzeugt sein kann. Als Material mit großem H_{c} sind zweckmäßigerweise hartmagnetische Legierungen von Fe, Co, Ni, für die eine ferromagnetische Schicht und als Material mit kleinem H_{c} für die andere ferromagnetische Schicht zweckmäßigerweise weichmagnetische Übergangsmetalllegierungen, beispielsweise Permalloy, vorgesehen. Als nichtmagnetisches Metall der Zwischenschicht können beispielsweise V, Ru, Cr oder Au gewählt werden.

Die Dicke der Zwischenschicht liegt unterhalb der mittleren freien Weglänge der Leitungselektronen. Vorteilhaft ist bei der zuletzt genannten Ausführungsart des Magnetfeldsensors eine Zwischenschicht mit einer Dicke von 1 bis 10 nm, da hierdurch die magnetischen Schichten entkoppelt werden.

Bei einer weiteren Ausführungsart des Magnetfeldsensors gemäß der Erfindung sind durch eine Zwischenschicht getrennte ferromagnetische Schichten vorgesehen, wobei an einer der ferromagnetischen Schichten eine weitere Schicht aus antiferromagnetischem Material anliegt. Bei dieser Ausführungsart des Magnetfeldsensors wird durch Ausnutzen der sog. "Austausch-Anisotropie", die an der Grenzfläche zwischen einem Ferro-und einem Antiferromagneten auftreten kann und die zu einer Verschiebung der Hysteresekurve der an der antiferromagnetischen Schicht anliegenden ferromagnetischen Schicht führt, die antiparallele Ausrichtung der Magnetisierungen der ferromagnetischen Schichten unter Einsatz eines äußeren Magnetfeldes Hb¹ erreicht.

Die ferromagnetischen Schichten bestehen dabei zweckmäßigerweise aus weichmagnetischen Übergangsmetallegierungen (z.B. Permalloy). Die Dicke der Zwischenschicht, die beispielsweise aus Au, Cr, V, Ru besteht, beträgt vorteilhafterweise 1 bis 10 nm.

Das antiferromagnetische Material der zusätzlichen Schicht ist zweckmäßigerweise MnFe.

Eine nächste Ausführungsart des Magnetfeldsensors gemäß der Erfindung weist die kennzeichnenden Merkmale des Anspruchs 8 auf. In diesem Falle wird die antiparallele Ausrichtung der Magnetisierung der ferromagnetischen Schichten durch antiferromagnetische Kopplung bewirkt. Die Zwischenschicht besteht dabei vornehmlich aus Cr oder Y. Ihre Dicke liegt im Bereich von 0,3 bis 2 nm. Sie ist bevorzugt einkristallin, wobei in der Regel - aufgrund der Herstellungsweise - auch die Schicht, auf der sie aufgewachsen ist, einkristallin ist.

Selbstverständlich können die Merkmale der verschiedenen Ausführungsarten in einem Magnetfeldsensor kombiniert sein.

Der Magnetfeldsensor gemäß der Erfindung ist in der Zeichnung schematisch dargestellt und wird im folgenden näher erläutert.

Es zeigen
- Figur 1: Magnetfeldsensor gemäß der Erfindung mit magnetischem Datenspeicher;
- Figur 2: Aufsicht des Sensors mit Bias-Feldern Hb¹ und Hb² und Signalfeld Hₛ;
- Figur 3: Querschnitt durch eine Schichtanordnung mit durch eine Zwischenschicht C getrennten ferromagnetischen Schichten A, B;
- Figur 4: Querschnitt durch eine Schichtanordnung mit zusätzlicher antiferromagnetischer Schicht D.

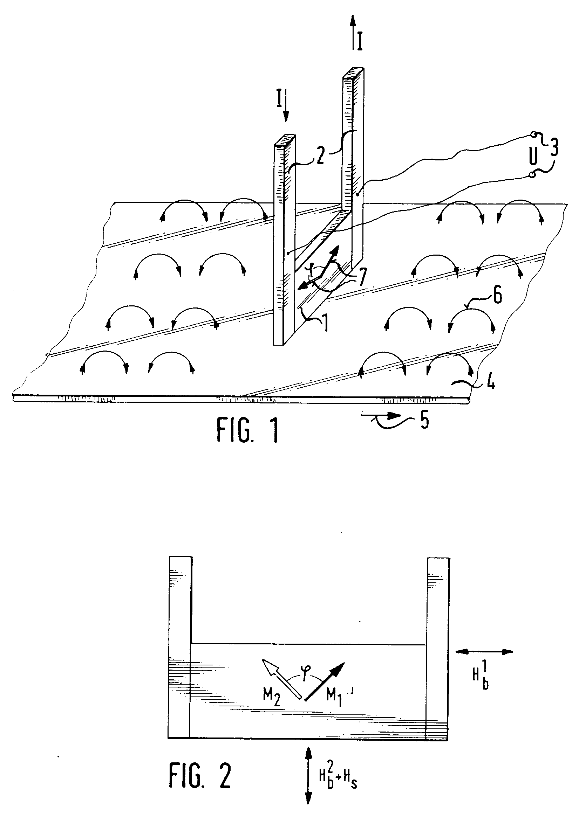

Der in Figur 1 dargestellte Magnetfeldsensor gemäß der Erfindung besteht aus einem Schichtpaket 1, den Stromkontakten 2 für den Strom I und den Spannungskontakten 3 für die Meßspannung U. Das Schichtpaket 1 besteht aus zwei ferromagnetischen Schichten, getrennt durch eine nichtferromagnetische Zwischenschicht. Die Magnetisierungen 7 der ferromagnetischen Schichten sind durch einen offenen und einen vollen Pfeil gekennzeichnet. Sie sind um einen Winkel gegeneinander verdreht. Bei der Signalaufnahme wird der Sensor relativ zum Datenspeicher 4 bewegt. Die Bewegungsrichtung ist durch 5 gekennzeichent. Dabei wird durch die aus dem Datenträger austretenden Magnetfelder (gebogene Pfeile 6) der Winkel φ verändert. Dies führt zu einer Änderung des elektrischen Widerstands des Sensors und erzeugt das Meßsignal über die am Sensor abgegriffene Spannung.

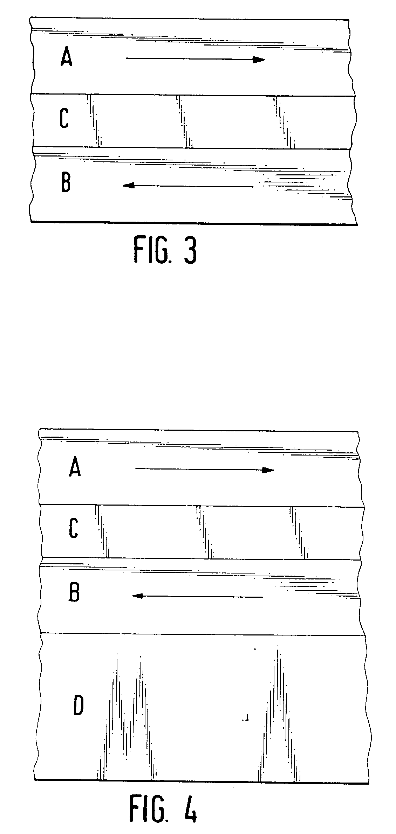

Figur 2 zeigt eine Frontansicht des Sensors. M₁ und M₂ sind die Magnetisierungen der beiden ferromagnetischen Schichten, Hₛ ist das Meßsignal, dem zur Einstellung des richtigen Wertes von φ noch ein Bias-Feld Hb² überlagert werden kann. Hb¹ ist ein Bias-Feld, das zur Erzeugung einer antiparallelen Ausrichtung von M₁ und M₂ vor dem Betrieb des Sensors dient.

Bei dem in Figur 3 gezeigten Schichtpaket kann eine antiparallele Magnetisierungsausrichtung der ferromagnetischen Schichten A, B auf zwei verschiedene Arten erzeugt werden. Ist die Zwischenschicht C genügend dick, so daß Schichten A und B über C entkoppelt sind, so kann durch ein geeignetes Bias-Feld Hb¹ eine antiparallele Ausrichtung von M₁ und M₂ dadurch erreicht werden, daß die beiden Schichten A und B verschiedenes H_{c} aufweisen. Bei geeignetem Zwischenschichtmaterial C kann die antiparallele Ausrichtung auch durch antiferromagnetische Zwischenschichtkopplung erreicht werden.

Figur 4 zeigt die Schichtfolge einer weiteren Ausführungsart des Magnetfeldsensors gemäß der Erfindung, bei der außer den Schichten A, B und C eine weitere Schicht D aus antiferromagnetischem Material (z.B. MnFe) vorgesehen ist. Das Material der Schichten A, B ist beispielsweise Permalloy, das der Schicht C beispielsweise Au oder Ru mit einer Dicke von ca. 5 nm. In diesem Fall ist die Hysterese von Schicht B durch den Austauschanisotropieeffekt in der Weise verschoben, daß über ein Bias-Feld Hb¹ wieder Antiparallelstellung erreicht werden kann.

## Patentansprüche

1. Magnetfeldsensor zum Auslesen magnetisch gespe cherter Daten, der wenigstens zwei über eine Zwischenschicht (C) benachbarte ferromagnetische dünne Schichten (A, B) aufweist, die aus Materialien bestehen, die bewirken, daß entweder ohne oder unter Mitwirkung eines äußeren Magnetfeldes (Hb¹, Hb²) die Magnetisierungsrichtungen (7) der beiden ferromagnetischen Schichten (A, B) in einer Komponente antiparallel zueinander stehen, wobei die Zwischenschicht (C) aus nicht-magnetischem Metall besteht, und mit zugehörigen Strom- (2) und Spannungskontakten (3),
**dadurch gekennzeichnet**,
daß die Zwischenschicht (C) eine Dicke aufweist, die kleiner als die mittlere freie Weglänge der Leitungselektronen dieser Zwischenschicht (C) ist und aus einem Material besteht, das bewirkt, daß an den Grenzflächen mit den ferromagnetischen Schichten (A, B) eine spinrichtungsabhängige Elektronenstreuung auftritt.

2. Magnetfeldsensor nach Anspruch 1,
**dadurch gekennzeichnet**,
daß für die ferromagnetischen Schichten (A, B) Materalien mit unterschiedlichen Koerzitivfeldstärken Hc vorgesehen sind.

3. Magnetfeldsensor nach Anspruch 2,
**dadurch gekennzeichnet,**
daß Übergangsmetalle wie Fe, Ni, Co und deren Legierungen, die in geeigneter Weise dotiert wurden, vorgesehen sind.

4. Magnetfeldsensor nach Anspruch 1,
**dadurch gekennzeichnet**,
daß eine zusätzliche Schicht (D) aus antiferromagnetischem Material vorgesehen ist, die an einer der beiden ferromagnetischen Schichten anliegt.

5. Magnetfeldsensor nach Anspruch 4,
**dadurch gekennzeichnet**,
daß für die ferromagnetischen Schichten (A, B) Materialien wie Fe, Co, Ni und weichmagnetische Legierungen hiervon vorgesehen sind.

6. Magnetfeldsensor nach einem der Ansprüche 2 bis 5,
**dadurch gekennzeichnet**,
daß für die Zwischenschicht (C) Materialien wie Au, Cr, V, Ru mit einer Dicke zwischen 1 und 10 nm vorgesehen sind.

7. Magnetfeldsensor nach Anspruch 4,
**dadurch gekennzeichnet,**
daß für die zusätzliche antiferromagnetische Schicht (D) MnFe vorgesehen ist.

8. Magnetfeldsensor nach Anspruch 1,
**dadurch gekennzeichnet,**
daß für die ferromagnetischen Schichten (A, B) Materialien wie Fe, Co, Ni und Legierungen hieraus vorgesehen sind und die Zwischenschicht (C) aus einem Material besteht, das antiferromagnetische Zwischenschichtkopplung zwischen den zwei ferromagnetischen Schichten bewirkt, so daß diese sich magnetisch antiparallel ausrichten.

9. Magnetfeldsensor nach Anspruch 8,
**dadurch gekennzeichnet,**
daß für die Zwischenschicht (C) Cr oder Y vorgesehen ist.

10. Magnetfeldsensor nach Anspruch 8,
**dadurch gekennzeichnet,**
daß für die Zwischenschicht (C) eine Dicke zwischen 0.3 und 2 nm vorgesehen ist.

## Claims

1. A magnetic field sensor for the read-out of magnetically stored data, which comprises at least two ferromagnetic thin layers (A, B) which adjoin via an intermediate layer (C) and which consist of materials which lead, either with or without the cooperation of an external magnetic field (Hb¹, Hb²), to the directions of magnetisation (7) of the two ferromagnetic layers (A, B) being situated antiparallel to each other in a component, wherein the intermediate layer (C) consists of non-magnetic metal, and with associated current- (2) and voltage contacts (3), characterised in that the intermediate layer (C) has a thickness which is less than the mean free path length of the conduction electrons of the said intermediate layer (C) and consists of a material which leads to the occurrence of a spin orientation-dependent electron scattering at the interfaces with the ferromagnetic layers (A, B).

2. A magnetic field sensor according to claim 1, characterised in that materials with different coercive field strengths Hc are provided for the ferromagnetic layers (A, B).

3. A magnetic field sensor according to claim 2, characterised in that transition metals such as Fe, Ni, Co and their alloys are provided, which are doped in a suitable manner.

4. A magnetic field sensor according to claim 1, characterised in that an additional layer (D) of antiferromagnetic material is provided, which adjoins one of the two ferromagnetic layers.

5. A magnetic field sensor according to claim 4, characterised in that materials such as Fe, Co, Ni and soft magnetic alloys thereof are provided for the ferromagnetic layers (A, B).

6. A magnetic field sensor according to any one of claims 2 to 5, characterised in that materials such as Au, Cr, V, Ru with a thickness between 1 and 10 nm are provided for the intermediate layer (C).

7. A magnetic field sensor according to claim 4, characterised in that MnFe is provided for the additional antiferromagnetic layer (D).

8. A magnetic field sensor according to claim 1, characterised in that materials such as Fe, Co, Ni and alloys thereof are provided for the ferromagnetic layers (A, B), and the intermediate layer (C) consists of a material which leads to antiferromagnetic interlayer coupling between the two ferromagnetic layers, so that the latter are aligned magnetically antiparallel.

9. A magnetic field sensor according to claim 8, characterised in that Cr or Y is provided for the intermediate layer (C).

10. A magnetic field sensor according to claim 8, characterised in that a thickness between 0.3 and 2 nm is provided for the intermediate layer (C).

## Revendications

1. Capteur de champ magnétique pour la lecture de données mémorisées magnétiquement, qui comporte au moins deux couches ferromagnétiques minces (A, B), qui sont disposées au voisinage l'une de l'autre avec interposition d'une couche intermédiaire (C) et qui sont réalisées en des matériaux agissant en sorte qu'avec ou sans la coopération d'un champ magnétique extérieur (Hb¹, Hb²), les directions d'aimantation (7) des deux couches ferromagnétiques (A, B) sont disposées selon un montage antiparallèle dans un composant, la couche intermédiaire (C) étant réalisée en un matériau amagnétique, et comportant des contacts associés de courant (2) et de tension (3), caractérisé par le fait que la couche intermédiaire (C) possède une épaisseur qui est inférieure au libre parcours moyen des électrons de conduction de cette couche intermédiaire (C) et qui est constituée en un matériau agissant en sorte qu'une dispersion d'électrons, qui dépend du sens du spin, apparaît au niveau des interfaces avec les couches ferromagnétiques (A, B).

2. Capteur de champ magnétique suivant la revendication 1, caractérisé par le fait que des matériaux possédant des intensités de champ coercitif (Hc) différentes sont prévus pour les couches ferromagnétiques (A, B).

3. Capteur de champ magnétique suivant la revendication 2, caractérisé par le fait qu'on prévoit des métaux de transition tels que Fe, Ni, Co et leurs alliages, que l'on a dopé de façon appropriée.

4. Capteur de champ magnétique suivant la revendication 1, caractérisé par le fait qu'il est prévu une couche supplémentaire (D) réalisée en un matériau antiferromagnétique qui s'applique contre l'une des deux couches ferromagnétiques.

5. Capteur de champ magnétique suivant la revendication 4, caractérisé par le fait que des matériaux tels que Fe, Co, Ni et des alliages magnétiques doux de ces matériaux sont prévus pour les couches ferromagnétiques (A, B).

6. Capteur de champ magnétique suivant l'une des revendications 2 à 5, caractérisé par le fait que les matériaux tels que Au, Cr, V, Ru, d'une épaisseur comprise entre 1 et 10 nm, sont prévus pour la couche intermédiaire (C).

7. Capteur de champ magnétique suivant la revendication 4, caractérisé par le fait que du MnFe est prévu pour la couche antiferromagnétique supplémentaire (D).

8. Capteur de champ magnétique suivant la revendication 1, caractérisé par le fait que des matériaux tels que Fe, Co, Ni et leurs alliages sont prévus pour les couches ferromagnétiques (A, B) et que la couche intermédiaire (C) est réalisée en un matériau qui établit un couplage antiferromagnétique de la couche intermédiaire entre les deux couches ferromagnétiques de sorte que ces dernières sont orientées selon une disposition antiparallèle du point de vue magnétique.

9. Capteur de champ magnétique suivant la revendication 8, caractérisé par le fait que du Cr ou du Y est prévu pour la couche intermédiaire (C).

10. Capteur de champ magnétique suivant la revendication 8, caractérisé par le fait qu'une épaisseur comprise entre 0,3 et 2 nm est prévue pour la couche intermédiaire (C).
